# EUROPÄISCHE PATENTSCHRIFT

(11) **EP 1 537 767 B1**
(45) Veröffentlichungstag und Bekanntmachung des Hinweises auf die Patenterteilung: **03.12.2008**
(21) Anmeldenummer: 04741946.0
(22) Anmeldetag: 02.07.2004
(51) Int. Cl.: H05K 9/00, H05K 1/14

(54) **ABSCHIRMUNG FÜR EMI-GEFÄHRDETE ELEKTRONISCHE BAUELEMENTE UND/ODER SCHALTUNGEN VON ELEKTRONISCHEN GERÄTEN**
SHIELDING FOR EMI-ENDANGERED ELECTRONIC COMPONENTS AND/OR CIRCUITS OF ELECTRONIC DEVICES
BLINDAGE POUR CIRCUITS ET/OU COMPOSANTS ELECTRONIQUES D'APPAREILS ELECTRONIQUES, EXPOSES A DES INTERFERENCES ELECTROMAGNETIQUES

(30) Priorität: 02.07.2003 DE 10329879
(43) Veröffentlichungstag der Anmeldung: 08.06.2005
(73) Patentinhaber: Siemens Home and Office Communications Devices GmbH & Co. KG, 81379 München (DE)
(72) Erfinder: LUNGWITZ, Matthias, 46397 Bocholt (DE)
(74) Vertreter: Maier, Daniel Oliver
(86) Internationale Anmeldenummer: PCT/EP2004/051332
(87) Internationale Veröffentlichungsnummer: WO 2005/004572

(56) Entgegenhaltungen:
- EP-A- 0 977 298
- US-B1- 6 486 534
- PATENT ABSTRACTS OF JAPAN Bd. 1997, Nr. 06, 30. Juni 1997 (1997-06-30) -& JP 09 036512 A (JAPAN AVIATION ELECTRON IND LTD), 7. Februar 1997 (1997-02-07)
- PATENT ABSTRACTS OF JAPAN Bd. 1998, Nr. 09, 31. Juli 1998 (1998-07-31) -& JP 10 112517 A (NGK SPARK PLUG CO LTD), 28. April 1998 (1998-04-28)
- PATENT ABSTRACTS OF JAPAN Bd. 2000, Nr. 25, 12. April 2001 (2001-04-12) -& JP 2001 237586 A (MATSUSHITA ELECTRIC IND CO LTD), 31. August 2001 (2001-08-31)
- "PRINTED CIRCUIT BOARD PATTERN DESIGN METHOD FOR LOW EMI NOISE" IBM TECHNICAL DISCLOSURE BULLETIN, IBM CORP. NEW YORK, US, Bd. 37, Nr. 6A, 1. Juni 1994 (1994-06-01), Seite 603, XP000455901 ISSN: 0018-8689

## Beschreibung

Die vorliegende Erfindung betrifft eine Abschirmung für EMI-gefährdete elektronische Bauelemente und/oder Schaltungen von elektronischen Geräten, insbesondere für Funksende- und/oder Funkempfangseinrichtungen von Telekommunikationsendgeräten zur drahtlosen Telekommunikation, wie Schnurlos- und Mobilfunktelefone und dergleichen.

Elektronische Geräte - z.B. Geräte der Konsumgüterindustrie wie der Unterhaltungselektronik, der Kommunikationstechnik u.s.w., z.B. Radio- und Fernsehapparate, HIFI-Anlagen, Telefone für drahtgebundene und drahtlose Kommunikation, Video-Handy's, Web- und LAN-Telefone, LAN-Adapter - weisen für die in dem jeweiligen Gerät zu realisierenden Funktionen und die dazu benötigten einzelnen Geräteteile überwiegend eine einzige Leiterplatte auf. Bei den Geräten, die mehr als zwei Leiterplatten aufweisen, wird bezüglich des Aufbaus der Leiterplatte die modulare Aufbautechnik angewandt. Die modulare Aufbautechnik kommt dabei vorzugsweise dann zum Einsatz, wenn die in dem elektronischen Gerät zu implementierenden Schaltungen und/oder Bauelemente an die hierfür vorgesehenen Leiterplatten unterschiedliche Anforderungen stellen. Der Begriff Schaltungen umfasst dabei Schaltungsbauteile, Schaltungselemente wie z.B. Leiterbahnstrukturen etc. und/oder Schaltungsverdrahtungen zwischen den Schaltungsbauteilen oder zwischen den Schaltungsbauteile bzw. Schaltungselementen und den Bauelementen.

So können beispielsweise in einem elektronischen HF-Schaltungen und HF-Bauelemente sowie NF-Schaltungen und NF-Bauelemente aufweisenden HF-Gerät die NF-Schaltungen und -Bauelemente aus Wirtschaftlichkeitserwägungen auf einer Leiterplatte integriert werden, die im Unterschied zu der Leiterplatte für die HF-Schaltungen und -Bauelemente bezüglich der Leiterplattenqualität wegen der unkritischeren physikalischen Eigenschaften der NF-Schaltungen und -Bauelemente geringeren Anforderungen genügen muss. Die Leiterplatte mit den HF-Schaltungen und -Bauelementen wird daher vorzugsweise mindestens eine z.B. mehrlagige FR4-Leiterplatte sein, während die Leiterplatte mit den NF-Schaltungen und -Bauelementen vorzugsweise höchstens eine z.B. mehrlagige FR2- oder FR3-Leiterplatte sein wird.

Dokument JP-9- 036512 offenbart eine Anordrung mit einer ersten Leiterplatle, die eine Ausnehmung aufweist, und mit einer zweiten Leiterplatte, auf der eletronische Bauelemente angeordnet sind, wobei du Bavelemente in der Ausnehmung verschwinden,

Um die elektromagnetische Ein- bzw. Abstrahlung von den HF-Schaltungen und -Bauelementen auf dem FR4-leiterplattenmodul zu minimieren, wird neben dem verbesserten Leiterplattenmaterial für das HF-Modul wieder ein Abschirmelement verwendet, das die EMI-gefährdeten elektronischen Bauelemente und/oder Schaltungen selbst oder aber das gesamte FR4-Leiterplattenmodul abschirmt.

Zur Abschirmung von Electro Magnetic Interference (EMI)-gefährdeten elektronischen Bauelementen und/oder Schaltungen, beispielsweise Hoch-Frequenz (HF)-Bauelemente und/oder Hoch-Frequenz (HF)-Schaltungen, wie sie in Funksende- und/oder Funkempfangseinrichtungen von Telekommunikationsendgeräten zur drahtlosen Telekommunikation, wie Schnurlos- und Mobilfunktelefone und dergleichen zum Einsatz kommen, ist es Stand der Technik, auf die Leiterplatte der EMI-gefährdeten elektronischen Bauelemente und/oder Schaltungen zusätzlich metallische und/oder keramische Abschirmelemente aufzusetzen, welche die EMI-gefährdeten elektronischen Bauelemente und/oder Schaltungen selbst oder aber die gesamte Leiterplatte abschirmen.

Als Abschirmelemente kommen dabei gemäß der US 5,895,884, EP 0 886 464 A2, EP 0 735 811 A2 und DE 199 45 427 C1 Abschirmgehäuse bzw. Abschirmvorrichtungen zum Einsatz, die auf eine Leiterplatte gelötet sind.

Bei schnurlosen Telefonen ist es beispielsweise bekannt, das Gehäuse als Ganzes oder Rahmen bzw. Deckel des Gehäuses mit Abschirmelementen zu versehen bzw. auszubilden oder aber die HF-Bauelemente und/oder HF-Schaltungen mit becher- bzw. topfförmigen metallischen Abschirmelementen abzudecken.

Ebenso ist es im Stand der Technik bekannt, HF-Bauelemente und/oder HF-Schaltungen mit Widerstandspasten und sogenannten Gore-Folien abzuschirmen, wobei die Gore-Folien üblicherweise zur Abschirmung von Kondensatoren verwendet werden.

Aus den Dokumenten JP-10 112517 A und US 6 486 534 B ist es bekannt durch Dorchkontaktierungen einen Käfig zu bilden, der die Bavelemente abschirmt.

Bei den vorbekannten Abschirmungen für hochfrequente elektrische Bauelemente und/oder Schaltungen ist die Verwendung zusätzlicher Abschirmelemente, sei es in Form von metallischen Abdeckungen für die hochfrequenten elektrischen Bauelemente und/oder Schaltungen oder die Verwendung von Widerstandspasten und Gore-Folien, nachteilig, da einerseits zusätzliche Fertigungs- und Montageschritte erforderlich sind und andererseits durch eine so ausgebildete Abschirmung der Raumbedarf der hochfrequenten elektrischen Bauelemente und/oder Schaltungen vergrößert wird.

Die der Erfindung zugrundeliegende Aufgabe besteht darin, eine Abschirmung für EMI-gefährdete elektronische Bauelemente und/oder Schaltungen von elektronischen Geräten, insbesondere für Funksende- und/oder Funkempfangseinrichtungen von Telekommunikationsendgeräten zur drahtlosen Telekommunikation, wie Schnurlos- und Mobilfunktelefone und dergleichen, bereitzustellen, welche ohne aufwendige Fertigungs- und Montagearbeiten ohne zusätzlichen Raumbedarf herstellbar ist.

Diese Aufgabe wird durch die im Patentanspruch 1 angegebenen Merkmale gelöst.

Die der Erfindung zugrundeliegende Idee besteht darin, EMI-gefährdete elektronische Bauelemente und/oder Schaltungen von elektronischen Geräten auf einer separaten, vorzugsweise als Leiterplattenmodul ausgebildeten, mindestens zweilagigen Leiterplatte anzuordnen. Diese Leiterplatte und eine weitere separate, mindestens zweilagige, Nicht-EMI-gefährdete elektronische Bauelemente und/oder Schaltungen und eine Ausnehmung für die EMI-gefährdeten elektronischen Bauelemente und/oder Schaltungen aufweisende, vorzugsweise als Grundleiterplatte ausgebildete Leiterplatte sind vorzugsweise im Bereich von Kontaktbereichen derart zu einer Einheit verbindungstechnisch, vorzugsweise durch Löten, zusammengefügt, dass durch die zwischen zwei metallischen als Masseflächen ausgebildeten Schichten (Leiterplattenlagen) angeordnete Ausnehmung, wobei die Masseflächen über sehr eng aneinander angeordnete Durchkontaktierungen jeweils mit den Kontaktbereichen verbunden sind, ein Käfig gebildet wird, der die EMI-gefährdeten elektronischen Bauelemente und/oder Schaltungen nach allen Seiten hin abschirmt.

Der Kontaktbereich kann entweder nur aus den darin mündenden Durchkontaktierungen gebildet sein oder er kann zusätzlich noch eine Abschirmfläche aufweisen, die mit den in den Kontaktbereich mündenden Durchkontaktierungen verbunden ist.

Bei dem Leiterplattenmodul befinden sich vorzugsweise auf der den EMI-gefährdeten Bauelementen und/oder Schaltungen abgewandten Seite die Massefläche, die das Leiterplattenmodul nahezu vollständig kaschiert, und auf der Bauelemente- und/oder Schaltungsseite der Kontaktbereich, der die Bauelemente und /oder Schaltungen umschließt. Bei der Grundleiterplatte befindet sich vorzugsweise auf der Leiterplattenseite mit der Ausnehmungsöffnung der Kontaktbereich, der die Ausnehmung umschließt, und auf der der Ausnehmungsöffnung abgewandten Leiterplattenseite die Massefläche, die die Bodenfläche der Ausnehmung flächenmäßig überragt oder mit dieser identisch ist.

Beim Zusammenfügen der beiden Leiterplatten - vorzugsweise im Bereich der Kontaktbereiche, wenn die beiden Leiterplatten übereinanderliegen, aufeinanderliegen oder sich berühren - verschwinden die EMI-gefährdeten elektronischen Bauelemente und/oder Schaltungen in der Ausnehmung. Durch die sehr eng aneinander, vorzugsweise in einem Abstand kleiner als ein Zehntel der Wellenlänge λ einer von elektronischen Bauelementen/Schaltungen ausgehenden elektromagnetischen Strahlung angeordneten Durchkontaktierungen, die für jede Leiterplatte die jeweilige Massefläche mit dem jeweiligen Kontaktbereich verbinden wird im zusammengefügten Zustand der Leiterplatten der Abschirmungskäfig gebildet.

Dies hat den Vorteil, dass das abzuschirmende Leiterplattenmodul keine weitere externe Abschirmvorrichtung benötigt und daher zusätzliche Materialkosten entfallen, weil durch den von den beiden Leiterplatten mit der Ausnehmung, den Durchkontaktierungen sowie den Masseflächen und den Kontaktbereichen gebildeten Käfig eine vergleichbare Abschirmung erreicht wird. Darüber hinaus ist nun auch eine eventuelle Reparatur auf dem Leiterplattenmodul möglich, weil in diesem Stadium der Herstellung eines Leiterplattenmoduls mit dazugehörigem Bauteil und/oder dazugehöriger Schaltung noch keine Abschirmung vorhanden ist. Dies erleichtert die Kontrolle von Lötstellen auf dem Modul im Rahmen der Qualitätssicherung bzw. Fehlersuche. Ebenfalls wird die Gesamtbauhöhe des Leiterplattenmoduls reduziert, da keine zusätzliche Abschirmvorrichtung auf dem Leiterplattenmodul benötigt wird.

Dadurch, dass die bestehende Grundleiterplatte als Abschirmung für ein Leiterplattenmodul mit EMI-gefährdeten elektronischen Bauelementen und/oder Schaltungen mitbenutzt wird, entfällt die Verwendung einer zusätzlichen Abschirmvorrichtung. Dabei ist es unerheblich, ob das Leiterplattenmodul auf der Grundleiterplatte bestückt ist oder ob die Grundleiterplatte auf dem Leiterplattenmodul bestückt ist. Dies bedeutet, dass, wenn wie im erstgenannten Fall die Adhäsionskraft von manchen Bauelementen und/oder Schaltungen beim nochmaligen Löten nicht ausreichend ist und sich diese infolgedessen vom "Lötpad" ablösen, die Grundleiterplatte auf dem Leiterplattenmodul bestückt wird.

Eine Abschirmung für EMI-gefährdete elektronische Bauelemente und/oder Schaltungen ist insbesondere in solchen Telekommunikationsendgeräten zur drahtlosen Telekommunikation sinnvoll, in denen ein HF-Modul, z.B. eine Funksende- und/oder Funkempfangseinrichtung, oder andere Schaltungsteile mit hoher Taktfrequenz, z.B. ein Mikroprozessor, zum Einsatz kommen.

Weitere Einzelheiten, Merkmale und Vorteile der Erfindung werden nachfolgend anhand des in den FIGUREN 1 bis 4 dargestellten Ausführungsbeispiels näher erläutert. Dabei zeigen:
- FIGUR 1: die Sicht auf eine für Nicht-EMI-gefährdete elektronische Bauelemente und/oder Schaltungen ausgelegte, als Grundleiterplatte ausgebildete erste Leiterplatte von der Bauelemente- und/oder Schaltungsseite aus,
- FIGUR 2: die Sicht auf eine für EMI-gefährdete elektronische Bauelemente und/oder Schaltungen ausgelegte, als Leiterplattenmodul ausgebildete zweite Leiterplatte von der Bauelemente- und/oder Schaltungsseite aus,
- FIGUR 3: die Sicht auf die für EMI-gefährdete elektronische Bauelemente und/oder Schaltungen ausgelegte, als Leiterplattenmodul ausgebildete zweite Leiterplatte von der der Bauelemente- und/oder Schaltungsseite abgewandten Leiterplattenseite aus,
- FIGUR 4: die Schnittdarstellungen der ersten Leiterplatte gemäß FIGUR 1 entlang der Schnittlinie A - A' mit Blick in Pfeilrichtung und der zweiten Leiterplatte gemäß den FIGUREN 2 und 3 jeweils entlang der Schnittlinie B - B' mit Blick in Pfeilrichtung.

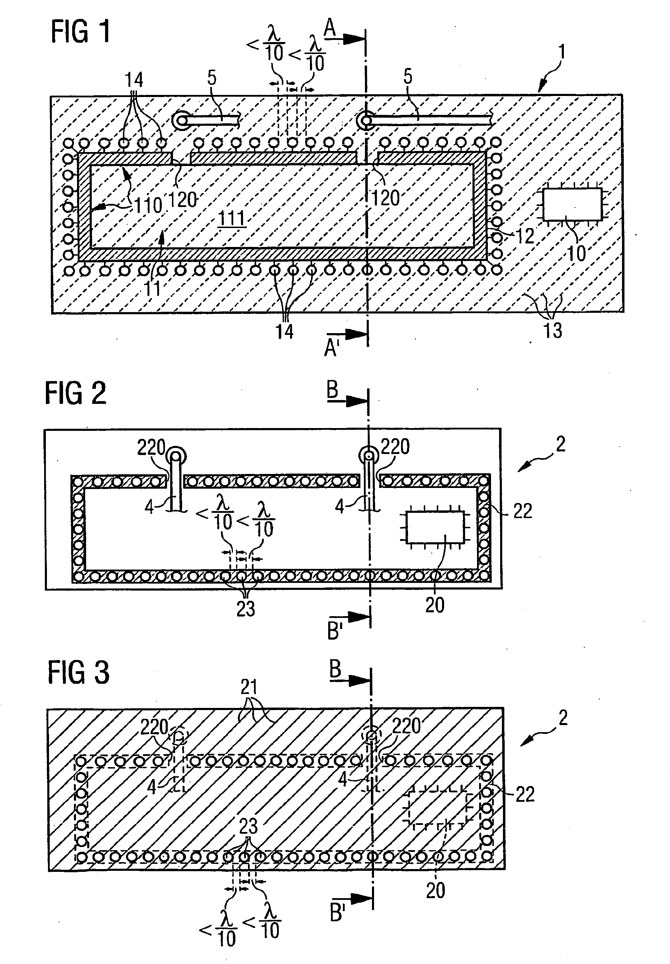

FIGUR 1 zeigt die Draufsicht auf eine vorzugsweise zweilagig, als Grundleiterplatte ausgebildete erste Leiterplatte 1, die auf einer Leiterplattenseite mit einer ersten Leiterplattenlage, stellvertretend für eine Vielzahl von Nicht-EMI-gefährdeten elektronischen Bauelementen und/oder Schaltungen ein Nicht-HF-Bauelement 10, das vorzugsweise als "Surface Mounting Device" ausgebildet ist, und auf einer gegenüberliegenden Leiterplattenseite mit einer zweiten Leiterplattenlage eine erste Massefläche 13 aufweist, die sich vorzugsweise über die gesamte Fläche der Leiterplatte 1 erstreckt. Dies ist aber, wie weiter unten erläutert wird, nicht zwingend notwendig. Da die Massefläche 13 durch die Draufsicht-Darstellung der Leiterplatte 1 in der FIGUR 1 nicht zu sehen ist, ist diese in der FIGUR 1 gestrichelt dargestellt. Die Masseflächen 13 kann vorzugsweise entweder als Vollfläche oder gerasterte Fläche mit einem Rasterabstand kleiner als ein Zehntel der Wellenlänge λ einer von elektronischen Bauelementen/Schaltungen ausgehenden elektromagnetischen Strahlung ausgebildet sein.

Alternativ, wenngleich nicht in der FIGUR 1 dargestellt, ist es auch möglich, dass das genannte Nicht-HF-Bauelement 10 oder weitere Bauelemente und/oder Schaltungen auf der zweiten Leiterplattenlage mit der Massefläche 13, jedoch getrennt von dieser angeordnet sind. Weiterhin ist es auch möglich, dass die Leiterplatte 1 mehr als zwei Leiterplattenlagen aufweist.

In der ersten Leiterplattenlage der Leiterplatte 1, auf der Bauelemente- und/oder Schaltungsseite, befindet sich neben dem Nicht-HF-Bauelement 10 eine Ausnehmungsöffnung 110 einer in die Leiterplatte 1 eingelassenen Ausnehmung 11. Die Ausnehmung 11 besitzt eine Bodenfläche 111, die zwischen der ersten Leiterplattenlage auf der Bauelemente- und /oder Schaltungsseite der Leiterplatte 1 und der zweite Leiterplattenlage auf der der Bauelemente- und/oder Schaltungsseite abgewandten Leiterplattenseite liegt.

Die Bodenfläche 111 und die Massefläche 13 sind flächenmäßig derart ausgebildet, dass die Massefläche 13 in der zweiten Leiterplattenlage zumindest der Fläche der Bodenfläche 111 der Ausnehmung 11 entspricht. Anstelle in der zweiten Leiterplattenlage angeordnet zu sein, ist es auch möglich, dass sich die Massefläche 13 zwischen der zweiten Leiterplattenlage und der Bodenfläche 111 oder sogar selbst in der Ebene der Bodenfläche 111 befinden kann, wenn jeweils sichergestellt ist, dass sich zwischen der Bodenfläche 111 und der Massefläche 13 keine Leitungen bzw. Leiterbahnen verlaufen. Hierauf muss insbesondere bei Leiterplatten mit mehr als zwei Leiterplattenlagen geachtet werden.

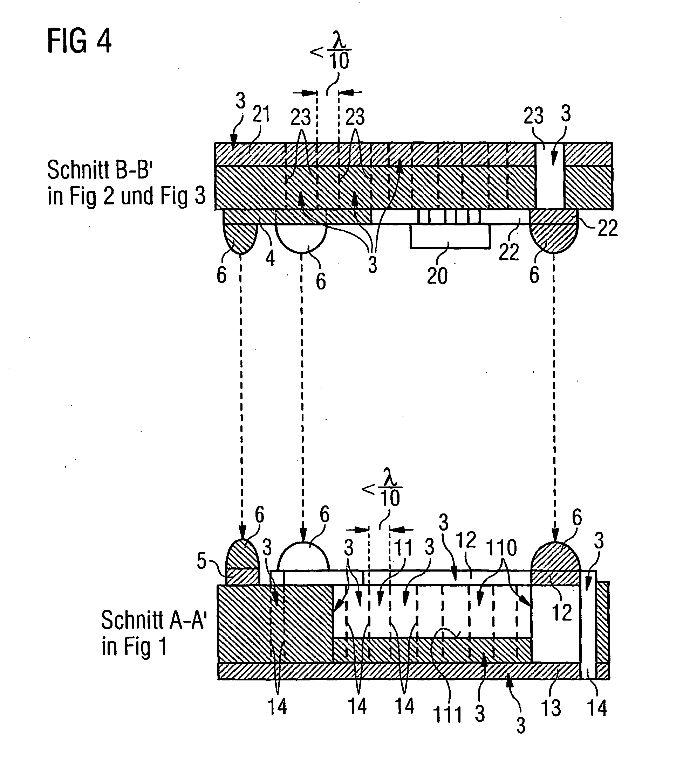

Die Ausnehmungsöffnung 110 der Ausnehmung 11 weist in der ersten Leiterplattenlage der Leiterplatte 1 einen metallischen Öffnungsrand auf, der zum Zweck der Abschirmung, die im folgenden bei der Beschreibung der FIGUR 4 näher erläutert wird, als eine erste Abschirmfläche 12 ausgebildet ist. In dem Öffnungsrand bzw. in der Abschirmfläche 12 sind erste Aussparungen 120 für Fremdleitungen 4 (vgl. FIGUR 2) vorgesehen, die so beschaffen sind, dass die Fremdleitungen 4 ohne die Abschirmfläche 12 zu berühren, also Kontakt mit der Abschirmfläche 12 zu haben, mit Signalleitungen 5, die sich außerhalb der Abschirmfläche 12 in der ersten Leiterplattenlage der Leiterplatte 1 befinden, verbunden werden können.

Der metallische Öffnungsrand bzw. die Abschirmfläche 12 ist weiterhin mit einer Vielzahl von vorzugsweise mit Harz gefüllten, ersten Durchkontaktierungen 14 elektrisch verbunden, die mit Ausnahme des Bereichs der Aussparungen 120 jenseits (außerhalb) der gesamten Abschirmfläche 12 auf der Leiterplatte 1 angeordnet sind. Der Abstand zwischen zwei benachbarten Durchkontaktierungen 14 auf der Leiterplatte 1 ist kleiner als λ/10, wobei λ die Wellenlänge der von elektronischen Bauelementen/Schaltungen ausgehenden elektromagnetischen Strahlung ist.

Die Durchkontaktierungen 14 erstrecken sich in der in FIGUR 1 dargestellten Leiterplatte 1 von der ersten Leiterplattenlage bis zur zweiten Leiterplattenlage und verbinden dabei die Abschirmfläche 12 in der ersten Leiterplattenlage mit der Massefläche 13 in der zweiten Leiterplattenlage. Es sei an dieser Stelle darauf hingewiesen, dass sich die Durchkontaktierungen 14, sobald die Massefläche 13 nicht mehr in der zweiten Leiterplattenlage liegt, sondern vielleicht in einer anderen Leiterplattenlage, die z.B. keine Außenlage ist, vorzugsweise nur bis zu dieser anderen Leiterplattenlage erstrecken.

Alternativ zu dem beschriebenen und dargestellten Aufbau der Leiterplatte 1, bei dem die Abschirmfläche 12 und die Durchkontaktierungen 14 einen ersten Kontaktbereich 12, 14 bilden, ist es auch möglich, auf die Abschirmfläche 12 zu verzichten. In diesem Fall wird der angegebene Kontaktbereich 12, 14 allein aus den Durchkontaktierungen 14 gebildet, die mit einem Ende in den Kontaktbereich münden, während sie am anderen Ende mit der Massefläche 13 verbunden sind.

FIGUR 2 zeigt die Draufsicht auf eine vorzugsweise zweilagig, als Leiterplattenmodul ausgebildete zweite Leiterplatte 2, die auf einer Leiterplattenseite mit einer ersten Leiterplattenlage, stellvertretend für eine Vielzahl von EMI-gefährdeten elektronischen Bauelementen und/oder Schaltungen ein HF-Bauelement 20, das vorzugsweise wieder als "Surface Mounting Device" ausgebildet ist, und auf einer gegenüberliegenden Leiterplattenseite mit einer zweiten Leiterplattenlage eine zweite Massefläche 21 aufweist. Da die Massefläche 21 durch die Draufsicht-Darstellung der Leiterplatte 2 in der FIGUR 2 nicht zu sehen ist, ist die Massefläche 21 und deren Ausbreitung auf der Leiterplatte 2 in FIGUR 3 gesondert dargestellt. Die Masseflächen 21 kann vorzugsweise wieder entweder als Vollfläche oder gerasterte Fläche mit einem Rasterabstand kleiner als ein Zehntel der Wellenlänge λ einer von elektronischen Bauelementen/Schaltungen ausgehenden elektromagnetischen Strahlung ausgebildet sein.

Weiterhin ist es auch wieder möglich, dass die Leiterplatte,2 wie die Leiterplatte 1 mehr als zwei Leiterplattenlagen aufweist.

In der ersten Leiterplattenlage der Leiterplatte 2, auf der Bauelemente- und/oder Schaltungsseite, befindet sich neben dem HF-Bauelement 20 eine zweite Abschirmfläche 22, die wieder zum Zweck der bei der Beschreibung der FIGUR 4 näher erläuterten Abschirmung dient und die bezüglich der Formgebung, der Abmaße, des Umfangs und des Materials der ersten Ab-schirmfläche 12 in der FIGUR 1 im wesentlichen entspricht.

Das bedeutet beispielsweise, dass die Abschirmfläche 22 wie die Abschirmfläche 12 an der gleichen Stelle zweite Aussparungen 220 aufweist, die den ersten Aussparungen 120 im Wesentlichen entsprechen.

In der Abschirmfläche 22 sind die Aussparungen 220 für Signalleitungen 4 vorgesehen, die den bei der Beschreibung der FIGUR 1 erwähnten Fremdleitungen entsprechen und die die Abschirmfläche 22 nicht berühren, also keinen Kontakt mit der Abschirmfläche 22 haben.

Die Abschirmfläche 22 ist weiterhin mit einer Vielzahl von vorzugsweise ebenfalls mit Harz gefüllten, zweiten Durchkontaktierungen 23 - wie die erste Abschirmfläche 12 mit den ersten Durchkontaktierungen 14 in der FIGUR 1 - elektrisch verbunden, die mit Ausnahme des Bereichs der Aussparungen 220 im Unterschied zu den Verhältnissen bei der FIGUR 1, also nicht jenseits (außerhalb) der gesamten Abschirmfläche 12 auf der Leiterplatte 1, sondern im Bereich der gesamten Abschirmfläche 22 auf der Leiterplatte 2 angeordnet sind.

Alternativ ist es aber auch möglich, dass die Durchkontaktierungen 23 wie die Durchkontaktierungen 14 auch jenseits (außerhalb) der gesamten Abschirmfläche 22 auf der Leiterplatte 2 angeordnet sind. Umgekehrt ist es allerdings auch möglich, dass die Durchkontaktierungen 14 in der FIGUR 1 wie die Durchkontaktierungen 23 in der FIGUR 2 im Bereich der gesamten Abschirmfläche 12 auf der Leiterplatte 1 angeordnet sind

Der Abstand zwischen zwei benachbarten Durchkontaktierungen 23 auf der Leiterplatte 2 ist wieder kleiner als λ/10, wobei λ die Wellenlänge der von elektronischen Bauelementen/Schaltungen ausgehenden elektromagnetischen Strahlung ist.

Die Durchkontaktierungen 23 erstrecken sich in der in FIGUR 2 dargestellten Leiterplatte 2 von der ersten Leiterplattenlage bis zur zweiten Leiterplattenlage und verbinden dabei die Abschirmfläche 22 in der ersten Leiterplattenlage mit der Massefläche 21 in der zweiten Leiterplattenlage. Es sei an dieser Stelle darauf hingewiesen, dass sich die Durchkontaktierungen 23, sobald die Massefläche 21 nicht mehr in der zweiten Leiterplattenlage liegt, sondern vielleicht in einer anderen Leiterplattenlage, die z.B. keine Außenlage ist, vorzugsweise nur bis zu dieser anderen Leiterplattenlage erstrecken.

Alternativ zu dem beschriebenen und dargestellten Aufbau der Leiterplatte 2, bei dem die Abschirmfläche 22 und die Durchkontaktierungen 23 einen zweiten Kontaktbereich 22, 23 bilden, ist es auch möglich, auf die Abschirmfläche 22 zu verzichten. In diesem Fall wird der angegebene Kontaktbereich 22, 23 allein aus den Durchkontaktierungen 23 gebildet, die mit einem Ende in den Kontaktbereich 22, 23 münden, während sie am anderen Ende mit der Massefläche 13 verbunden sind.

FIGUR 3 zeigt ausgehend von FIGUR 2 die Draufsicht auf die vorzugsweise zweilagig, als Leiterplattenmodul ausgebildete zweite Leiterplatte 2, die auf der Leiterplattenseite mit der zweiten Leiterplattenlage die zweite Massefläche 21 und auf der gegenüberliegenden Leiterplattenseite mit der ersten Leiterplattenlage, stellvertretend für die Vielzahl der EMI-gefährdeten elektronischen Bauelemente und/oder Schaltungen das HF-Bauelement 20 aufweist. Da das HF-Bauelement 20 und die Signalleitungen 4 durch die Draufsicht-Darstellung der Leiterplatte 2 in der FIGUR 3 nicht zu sehen sind, sind diese in der FIGUR 3 gestrichelt dargestellt.

Die Durchkontaktierungen 23 sind in der FIGUR 3 nicht gestrichelt eingezeichnet, weil diese durch die Massefläche 21 nicht verdeckt werden, also sichtbar sind. Dies liegt daran, dass die Durchkontaktierungen 23 prozesstechnisch erst am Schluss, also nach dem Aufbringen der Massefläche 21 auf die zweite Leiterplattenlage der Leiterplatte 2, durch Bohren der Leiterplatte 2 erzeugt werden.

FIGUR 4 zeigt eine Querschnitts-/Explosionsdarstellung, bei der die erste Leiterplatte 1 gemäß der FIGUR 1 entlang der Schnittlinie A - A' mit Blick in Pfeilrichtung und die zweite Leiterplatte 2 gemäß den FIGUREN 2 und 3 jeweils entlang der Schnittlinie B - B' mit Blick in Pfeilrichtung im unverbundenen Zustand (Explosionszustand) dargestellt sind.

Bezüglich der vorzugsweise als Grundleiterplatte ausgebildeten ersten Leiterplatte 1 ist zu sehen, wie die Ausnehmung 11 mit der Bodenfläche 111 und der Ausnehmungsöffnung 110 in die Leiterplatte 1 eingelassen ist und wie die Massefläche 13, die die Ausnehmungsöffnung 110 umschließende erste Abschirmfläche 12 und die im Abstand von kleiner als λ/10 von einander entfernten ersten Durchkontaktierungen 14 zusammen mit der Ausnehmung 11 einen bezogen auf die erste Leiterplatte 1 ersten Teil eines Abschirmungskäfigs 3, sozusagen einen Abschirmkäfig 3 ohne Käfigdeckel, bilden.

Bezüglich der vorzugsweise als Leiterplattenmodul ausgebildeten zweiten Leiterplatte 2 ist zu sehen, wie die Massefläche 21, die zur ersten Abschirmfläche 12 in der FIGUR 1 im wesentlichen deckungsgleiche zweite Abschirmfläche 22 und die wieder im Abstand von kleiner als λ/10 von einander entfernten zweiten Durchkontaktierungen 23 einen bezogen auf die zweite Leiterplatte 2 zweiten Teil des Abschirmungskäfigs 3, sozusagen den Käfigdeckel des Abschirmkäfigs 3, bilden und wie das HF-Bauelement 20, wenn die zweite Leiterplatte 2 in Richtung der gestrichelten Pfeile auf die erste Leiterplatte 1 gelegt wird, in der Ausnehmung 11 und damit in dem Abschirmungskäfig 3 verschwindet, der das das HF-Bauelement 20 nach allen Seiten hin abschirmt.

Die beiden Leiterplatten 1, 2 werden in dem Zustand, wenn diese im Bereich der Abschirmflächen 12, 22 übereinanderliegen, aufeinanderliegen oder sich berühren, vorzugsweise durch Lötballs 6 im Bereich dieser Abschirmflächen 12, 22 miteinander verbunden. Alternativ sind aber auch andere, die gleiche Wirkung erzielende (Haftwirkung) Verbindungstechniken als das Löten, wie z.B. Kleben, möglich.

Sind die Abschirmflächen, wie vorstehend angedeutet nicht vorhanden, so erfolgt die Verbindung der beiden Leiterplatten 1, 2 in dem angegebenen Zustand im Bereich der Durchkontaktierungen 14, 23. Alternativ ist es aber auch möglich, die beiden Leiterplatten 1, 2 in dem angegebenen Zustand auch außerhalb der Kontaktbereiche 12, 14, 22, 23 zu verbinden.

Mit der Löt- bzw. Klebverbindung der beiden Leiterplatten 1 werden auch die Signalleitungen 4, 5 mit einander verbunden. Wegen der notwendigen elektrischen Verbindung wird hier vorzugsweise das Löten mittels der Lötballs 6 als Verbindungstechnik eingesetzt. Sollten auch hier andere mögliche Verbindungstechniken in Erwägung gezogen werden, so muss lediglich darauf geachtet werden, dass die alternative Verbindungstechnik eine elektrische Verbindung zwischen den Signalleitungen sicherstellt.

## Patentansprüche

1. Abschirmung für EMI-gefährdete elektronische Bauelemente und/oder Schaltungen von elektronischen Geräten, wobei
a) eine mindestens zweilagige erste Leiterplatte (1) für Nicht-EMI-gefährdete elektronische Bauelemente und/oder Schaltungen (10) vorhanden ist, die eine Ausnehmung (11) mit einer Ausnehmungsöffnung (110) und einer Bodenfläche (111) aufweist und auf der die Nicht-EMI-gefährdeten elektronischen Bauelemente und/oder Schaltungen (10) zumindest einseitig angeordnet sind,
b) die erste Leiterplatte (1) auf der Leiterplattenseite mit der Ausnehmungsöffnung (110) einen die Ausnehmungsöffnung (110) umschließenden ersten Kontaktbereich (12, 14) aufweist,
c) die erste Leiterplatte (1) auf einer Leiterplattenlage, die zwischen der Bodenfläche (111) der Ausnehmung (11) und der der Ausnehmungsöffnung (110) abgewandten Leiterplattenseite oder in der Ebene der Bodenfläche (111) oder in der Ebene der der Ausnehmungsöffnung (110) abgewandten Leiterplattenseite liegt, eine erste Massefläche (13) aufweist, die flächenmäßig zumindest der Fläche der Bodenfläche (111) der Ausnehmung (11) entspricht,
d) die Nicht-EMI-gefährdeten elektronischen Bauelemente und/oder Schaltungen (10) außerhalb der Ausnehmung (11) jenseits des ersten Kontaktbereiches (12, 14) bzw. der ersten Massefläche (13) angeordnet sind,
e) eine mindestens zweilagige zweite Leiterplatte (2) für EMI-gefährdete elektronische Bauelemente und/oder Schaltungen (20) vorhanden ist, auf der die EMI-gefährdeten elektronischen Bauelemente und/oder Schaltungen (20) einseitig angeordnet sind,
f) die zweite Leiterplatte (2) auf einer Leiterplattenlage, die zwischen der Bauelemente-/Schaltungsseite und der der Bauelemente-/Schaltungsseite abgewandten Leiterplattenseite oder in der Ebene der der Bauelemente-/Schaltungsseite abgewandten Leiterplattenseite liegt, eine flächenmäßig im wesentlichen der Grundfläche der zweiten Leiterplatte (2) entsprechende zweite Massefläche (21) aufweist,
g) die zweite Leiterplatte (2) auf der Bauelemente-/Schaltungsseite einen die EMI-gefährdeten elektronischen Bauelemente und/oder Schaltungen (20) umschließenden zweiten Kontaktbereich (22, 23) aufweist,
h) die zweite Leiterplatte (2) derart auf der ersten Leiterplatte (1) angeordnet ist, dass diese verbindungstechnisch, insbesondere durch Löten, zusammengefügt sind und dabei die EMI-gefährdeten elektronischen Bauelemente und/oder Schaltungen (20) auf der zweiten Leiterplatte (2) in der Ausnehmung (11) der ersten Leiterplatte (1) verschwinden,
i) Durchkontaktierungen (14, 23) auf den beiden Leiterplatten (1, 2) vorhanden sind, die für jede Leiterplatte (1, 2) jeweils an einem Ende mit der jeweilige Massefläche (13, 21) verbunden sind und mit dem anderen Ende jeweils in den jeweiligen Kontaktbereich (12, 14, 22, 23) münden und dabei derart angeordnet sind, dass die Durchkontaktierungen (14, 23) zusammen mit der Ausnehmung (11) und den Masseflächen (13, 21) einen Käfig (3) bilden, in dem die in der Ausnehmung (11) befindlichen EMI-gefährdeten elektronischen Bauelemente und/oder Schaltungen (20) nach allen Seiten hin abgeschirmt sind.

2. Abschirmung nach Anspruch 1, **dadurch gekennzeichnet, dass** die Durchkontaktierungen (14, 23) in einem Abstand kleiner als ein Zehntel der Wellenlänge λ einer von elektronischen Bauelementen/Schaltungen ausgehenden elektromagnetischen Strahlung voneinander angeordnet sind.

3. Abschirmung nach Anspruch 1 oder 2, **dadurch gekennzeichnet, dass** die Durchkontaktierungen (14, 23) die Masseflächen (13, 21) durchstoßen.

4. Abschirmung nach Anspruch 1, 2 oder 3, **dadurch gekennzeichnet, dass** die Durchkontaktierungen (14, 23) mit einem Füllmaterial, vorzugsweise Harz, gefüllt sind.

5. Abschirmung nach Anspruch 1, **dadurch gekennzeichnet, dass** die Kontaktbereiche (12, 14, 22, 23) jeweils mindestens an zwei Stellen jeweils zwischen zwei Durchkontaktierungen (14, 23) für erste Signalleitungen (4) zum Zu- und Abführen von Signalen zu bzw. von den EMI-gefährdeten elektronischen Bauelemente und/oder Schaltungen (20) auf der zweiten Leiterplatte (2) durch Aussparungen (120, 220) unterbrochen sind, so dass die ersten Signalleitungen (4), wenn die beiden Leiterplatten (1, 2) verbindungstechnisch zusammengefügt sind und sich die EMI-gefährdeten elektronischen Bauelemente und/oder Schaltungen (20) in der Ausnehmung (11) befinden, mit zweiten Signalleitungen (5) außerhalb der Ausnehmung (11) auf der ersten Leiterplatte (1) elektrisch verbunden sind.

6. Abschirmung nach Anspruch 1 oder 3, **dadurch gekennzeichnet, dass** die Masseflächen (13, 21) als Vollflächen oder gerasterte Flächen mit einem Rasterabstand kleiner als ein Zehntel der Wellenlänge λ einer von elektronischen Bauelementen/Schaltungen ausgehenden elektromagnetischen Strahlung ausgebildet sind.

7. Abschirmung nach Anspruch 1, **dadurch gekennzeichnet, dass** die Nicht-EMI-gefährdeten und EMI-gefährdeten elektronischen Bauelemente (10, 20) als "Surface Mounting Devices" ausgebildet sind.

8. Abschirmung nach Anspruch 1, **dadurch gekennzeichnet, dass** die Nicht-EMI-gefährdeten und EMI-gefährdeten elektronischen Schaltungen (10, 20) Schaltungsbausteine, Schaltungselemente und/oder Schaltungsverdrahtungen beinhalten.

9. Abschirmung nach Anspruch 1, **dadurch gekennzeichnet, dass** der erste Kontaktbereich (12, 14) eine erste Abschirmfläche (12) aufweist, die von ersten Durchkontaktierungen (14) in der ersten Leiterplatte (1) durchstoßen wird oder die mit den ersten Durchkontaktierungen (14) in der ersten Leiterplatte (1) verbunden ist und dass der zweite Kontaktbereich (22, 23) eine zweite Abschirmfläche (22) aufweist, die von zweiten Durchkontaktierungen (23) in der zweiten Leiterplatte (2) durchstoßen wird oder die mit den zweiten Durchkontaktierungen (23) in der zweiten Leiterplatte (2) verbunden ist.

10. Abschirmung nach Anspruch 1 oder 9, **dadurch gekennzeichnet, dass** die Leiterplatten (1, 2) im Bereich der Kontaktbereich (12, 14, 22, 23) verbindungstechnisch zusammengefügt sind.

## Claims

1. Shielding for EMI-endangered electronic components and/or circuits of electronic devices, wherein
a) an at least double-layered first printed circuit board (1) for non-EMI-endangered electronic components and/or circuits (10) is present and includes a recess (11) having a recess opening (110) and a base surface (111), on at least one side of which first printed circuit board (1) the non-EMI-endangered electronic components and/or circuits (10) are arranged,
b) the first printed circuit board (1) includes on the side with the recess opening (110) a first contact area (12, 14) encompassing the recess opening (110),
c) the first printed circuit board (1) has a first earth face (13) on a printed circuit board layer disposed between the base surface (111) of the recess (11) and the side of the printed circuit board facing away from the recess opening (110), or in the plane of the base surface (111) or in the plane of the side of the printed circuit board facing away from the recess opening (110), which first earth face (13) corresponds in area to at least the area of the base surface (111) of the recess (11),
d) the non-EMI-endangered electronic components and/or circuits (10) are arranged outside the recess (11) beyond the first contact area (12, 14) or the first earth face (13),
e) an at least double-layered second printed circuit board (2) for EMI-endangered electronic components and/or circuits (20) is present, on one side of which the EMI-endangered electronic components and/or circuits (20) are arranged,
f) the second printed circuit board (2) has a second earth face (21) corresponding in area substantially to the base area of the second printed circuit board (2), on a printed circuit board layer disposed between the components side/circuits side and the side facing away from the components side/circuits side, or in the plane of the side facing away from the components side/circuits side,
g) the second printed circuit board (2) has on the components side/circuits side a second contact area (22, 23) encompassing the EMI-endangered electronic components and/or circuits (20),
h) the second printed circuit board (2) is arranged on the first printed circuit board (1) in such a way that said printed circuit boards (1, 2) are joined together by joining technology, in particular by soldering, and the EMI-endangered electronic components and/or circuits (20) on the second printed circuit board (2) disappear in the recess (11) of the first printed circuit board (1),
i) interfacial connections (14, 23) are present on both printed circuit boards (1, 2) and in the case of each printed circuit board (1, 2) are connected by one end to the respective earth face (13, 21) and lead with the other end to the respective contact area (12, 14, 22, 23), and are so arranged that the interfacial connections (14, 23), together with the recess (11) and the earth faces (13, 21), form a cage (3) in which the EMI-endangered electronic components and/or circuits (20) located in the recess (11) are shielded on all sides.

2. Shielding according to claim 1, **characterised in that** the interfacial connections (14, 23) are spaced apart by a distance of less than one-tenth of the wavelength λ of an electromagnetic radiation emitted by electronic components/circuits.

3. Shielding according to claim 1 or 2, **characterised in that** the interfacial connections (14, 23) pass through the earth faces (13, 21).

4. Shielding according to claim 1, 2, or 3, **characterised in that** the interfacial connections (14, 23) are filled with a filling material, preferably resin.

5. Shielding according to claim 1, **characterised in that** the contact areas (12, 14, 22, 23) are in each case interrupted in at least two places by gaps (120, 220), located in each case between two interfacial connections (14, 23), for first signal lines (4) for conveying signals to and from the EMI-endangered electronic components and/or circuits (20) on the second printed circuit board (2), so that the first signal lines (4) are electrically connected to second signal lines (5) outside the recess (11) on the first printed circuit board (1) when the two printed circuit boards (1, 2) have been joined together by joining technology and the EMI-endangered electronic components and/or circuits (20) are located in the recess (11).

6. Shielding according to claim 1 or 3, **characterised in that** the earth faces (13, 21) are configured as continuous faces or as grid faces with a grid line spacing of less than one-tenth of the wavelength λ of an electromagnetic radiation emitted by electronic components/circuits.

7. Shielding according to claim 1, **characterised in that** the non-EMI-endangered and EMI-endangered electronic components (10, 20) are in the form of surface mounting devices.

8. Shielding according to claim 1, **characterised in that** the non-EMI-endangered and EMI-endangered electronic circuits (10, 20) contain circuit modules, circuit elements and/or circuit wiring.

9. Shielding according to claim 1, **characterised in that** the first contact area (12, 14) includes a first shielding face (12) through which first interfacial connections (14) in the first printed circuit board (1) pass, or which is connected to the first interfacial connections (14) in the first printed circuit board (1), and **in that** the second contact area (22, 23) includes a second shielding face (22) through which second interfacial connections (23) in the second printed circuit board (2) pass, or which is connected to the second interfacial connections (23) in the first printed circuit board (2).

10. Shielding according to claim 1 or 9, **characterised in that** the printed circuit boards (1, 2) are joined together in the region of the contact areas (12, 14, 22, 23) by joining technology.

## Revendications

1. Blindage pour composants et/ou circuits électroniques d'appareils électroniques, exposés à des interférences électromagnétiques,
a) une première carte de circuits (1), comportant au moins deux couches, pour des composants et/ou circuits électroniques (10) non exposés à des interférences électromagnétiques, étant présente, laquelle comporte un évidement (11) avec un orifice d'évidemment (110) et une surface de fond (111) et sur laquelle sont disposés, au moins sur un côté, les composants et/ou circuits électroniques (10) non exposés à des interférences électromagnétiques,
b) la première carte de circuits (1) comportant, sur le côté de la carte de circuits avec l'orifice de l'évidement (110), une première zone de contact (12, 14) qui entoure l'orifice de l'évidement (110),
c) la première carte de circuits (1) comportant, sur une couche de la carte de circuits située entre la surface de fond (111) de l'évidement (11) et le côté de la carte de circuits opposé à l'orifice de l'évidement (110) ou dans le plan de la surface de fond (111) ou dans le plan du côté de la carte de circuits opposé à l'orifice de l'évidemment (110), une première surface de masse (13) dont la superficie correspond au moins à la superficie de la surface de fond (111) de l'évidement (11),
d) les composants et/ou circuits électroniques (10) non exposés à des interférences électromagnétiques étant situés en dehors de l'évidement (11) au-delà de la première zone de contact (12, 14) resp. de la première surface de masse (13),
e) une deuxième carte de circuits (2), comportant au moins deux couches, pour des composants et/ou circuits électroniques (20) exposés à des interférences électromagnétiques, étant présente, sur laquelle sont situés, sur un côté, les composants et/ou circuits électroniques (20) exposés à des interférences électromagnétiques,
f) la deuxième carte de circuits (2) comportant, sur une couche de la carte de circuits située entre le côté des composants / des circuits et le côté de la carte de circuits opposé au côté des composants / des circuits ou dans le plan du côté de la carte de circuits opposé au côté des composants / circuits, une deuxième surface de masse (21) dont la superficie correspond sensiblement à la surface de base de la deuxième carte de circuits (2),
g) la deuxième carte de circuits (2) comportant, sur le côté des composants / des circuits, une deuxième zone de contact (22, 23) qui entoure les composants et/ou circuits électroniques exposés à des interférences électromagnétiques,
h) la deuxième carte de circuits (2) étant disposée de manière telle sur la première carte de circuits (1) que celles-ci sont assemblées par une technique d'assemblage, en particulier par brasage, et les composants et/ou circuits électroniques (20) exposés à des interférences électromagnétiques, sur la deuxième carte de circuits (2), disparaissent dans l'évidement (11) de la première carte de circuits (1),
i) des connexions transversales (14, 23) étant présentes sur les deux cartes de circuits (1, 2), dont une extrémité est, pour chaque carte de circuits (1, 2), respectivement reliée à la surface de masse respective (13, 21) et qui débouchent chacune en leur autre extrémité dans la zone de contact respective (12, 14, 22, 23) tout en étant situées de manière telle que les connexions transversales (14, 23) constituent, conjointement avec l'évidement (11) et les surfaces de masse (13, 21), une cage (3) dans laquelle les composants et/ou circuits électroniques (20) exposés à des interférences électromagnétiques et qui se trouvent dans l'évidement (11) sont blindés de toutes parts.

2. Blindage selon la revendication 1, **caractérisé en ce que** les connexions transversales (14, 23) sont espacées de moins d'un dixième de la longueur d'onde λ d'un rayonnement électromagnétique émanant de composants /circuits électroniques.

3. Blindage selon la revendication 1 ou 2, **caractérisé en ce que** les connexions transversales (14, 23) traversent les surfaces de masse (13, 21).

4. Blindage selon la revendication 1, 2 ou 3, **caractérisé en ce que** les connexions transversales (14, 23) sont remplies d'un matériau de remplissage, de préférence de résine.

5. Blindage selon la revendication 1, **caractérisé en ce que** les zones de contact (12, 14, 22, 23) sont chacune interrompues au moins à deux endroits par des creux (120, 220) respectivement entre deux connexions transversales (14, 23) pour de premières lignes de signaux (4) pour amener et transporter des signaux de resp. vers les composants et/ou circuits électroniques (20) exposés à des interférences électromagnétiques, de sorte que les premières lignes de signaux (4), lorsque les deux cartes de circuits (1, 2) sont assemblées par une technique d'assemblage et les composants et/ou circuits électroniques (20) exposés à des interférences électromagnétiques se trouvent dans l'évidement (11), sont reliées électriquement à de deuxièmes lignes de signaux (5) en dehors de l'évidement (11) sur la première carte de circuits (1).

6. Blindage selon la revendication 1 ou 3, **caractérisé en ce que** les surfaces de masse (13, 21) se présentent de préférence sous la forme de surfaces pleines ou de surfaces tramées avec une distance de trame inférieure à un dixième de la longueur d'onde λ d'un rayonnement électromagnétique émanant de composants / circuits électroniques.

7. Blindage selon la revendication 1, **caractérisé en ce que** les composants électroniques non exposés à des interférences électromagnétiques et exposés à des interférences électromagnétiques (10, 20) se présentent sous la forme de «Surface Mounting Devices».

8. Blindage selon la revendication 1, **caractérisé en ce que** les circuits électroniques non exposés à des interférences électromagnétiques et exposés à des interférences électromagnétiques (10, 20) contiennent des composants de circuits, des éléments de circuits et/ou des interconnexions de circuits.

9. Blindage selon la revendication 1, **caractérisé en ce que** la première zone de contact (12, 14) comporte une première surface de blindage (12) qui est traversée par de premières connexions transversales (14) dans la première carte de circuits (1) ou qui est reliée aux premières connexions transversales (14) dans la première carte de circuits (1) et **en ce que** la deuxième zone de contact (22, 23) comporte une deuxième surface de blindage (22) qui est traversée par de deuxièmes connexions transversales (23) dans la deuxième carte de circuits (2) ou qui est reliée aux deuxièmes connexions transversales (23) dans la deuxième carte de circuits (2).

10. Blindage selon la revendication 1 ou 9, **caractérisé en ce que** les cartes de circuits (1, 2) sont assemblées par une technique d'assemblage dans la partie des zones de contact (12, 14, 22, 23).
